# EUROPÄISCHE PATENTSCHRIFT

(11) **EP 0 646 971 B1**
(45) Veröffentlichungstag und Bekanntmachung des Hinweises auf die Patenterteilung: **12.03.1997**
(21) Anmeldenummer: 94115290.2
(22) Anmeldetag: 28.09.1994
(51) Int. Cl.: H01L 31/0203, H01L 33/00

(54) **Zweipoliges SMT-Miniatur-Gehäuse für Halbleiterbauelemente und Verfahren zu dessen Herstellung**
Two-terminal SMT-miniature-housing of semiconductor device and process of manufacturing the same
Boîtier miniature SMT à deux bornes pour dispositif semi-conducteur et son procédé de fabrication

(30) Priorität: 30.09.1993 DE 4333392
(43) Veröffentlichungstag der Anmeldung: 05.04.1995
(73) Patentinhaber: SIEMENS AKTIENGESELLSCHAFT, 80333 München (DE)
(72) Erfinder: Waitl, Ing. Günther,, D-93049 Regensburg (DE); Schellhorn, Franz, D-93049 Regensburg (DE); Brunner, Dipl.-Ing. Herbert, D-93047 Regensburg (DE)

(56) Entgegenhaltungen:
- DE-A- 2 829 260
- PATENT ABSTRACTS OF JAPAN, vol. 16, no. 393 (P-1406) 20. August 1992; & JP-A-04 128 811

## Beschreibung

Die Erfindung betrifft ein zweipoliges SMT(Surface Mount Technology)-Miniaturgehäuse in Leadframetechnik für Halbleiterbauelemente, bei dem ein Halbleiterchip auf ein Leadframeteil montiert und mit einem weiteren Leadframeteil kontaktiert ist, die als Lötanschlüsse aus dem Gehäuse herausgeführt sind, in das der Chip eingekapselt ist.

Bei den bekannten SMT-Gehäusen in Leadframe-Technik, z.B. bei einem SOD 123-Gehäuse, müssen die Lötanschlüsse für das Halbleiterbauelement nach dessen Einkapseln, das beispielsweise durch Vergießen, Umpressen oder Umspritzen geschieht, freigestanzt und in einer bestimmten Art und Weise gebogen werden. Dieser Trimm- und Form-Prozeß ist notwendig, um die Lötanschlüsse so am Gehäuse vorbeizuführen, daß solche SMD's (Surface Mounted Devices) auf eine Leiterplatte bzw. Platine montiert werden können. Die Chip-Montagefläche auf dem Leadframe verläuft dabei im montierten Zustand parallel zum PCB (Printed Circuit Board) bzw. zur Leiterplatte oder Platine.

Ein SMT-Miniaturgehäuse für optoelektronische Halbleiterbauelemente in dem die Lötanschlüsse seitlich aus dem gehäuse herausrogen und durch Biegen bis zum Gehäuseboden geführt werden ist aus Patent Abstracts of Japan Band 16 Nr 393 (P-1406), 20 August 1992 & JP-A-04 128 811 bekannt.

Der Erfindung liegt die Aufgabe zugrunde, ein SMT-Miniaturgehäuse für Halbleiterbauelemente zu schaffen, das ohne einen solchen Trimm- und Formprozeß rationell herstellbar, zuverlässig dicht sowie weiter miniaturisierbar ist und sich durch eine hohe Wärmeableitung auszeichnet.

Diese Aufgabe wird bei einem zweipoligen SMT-Miniaturgehäuse der eingangs genannten Art erfindungsgemäß dadurch gelöst, daß die Lötanschlüsse als fertige Bauteile in Form von Stanzteile des Leadframes von einander gegenüberliegenden Gehäuseseitenwänden seitlich abstehend mindestens bis zum die Bauelementmontagefläcne bildenden Genäuseboden geführt sind, wobei die Chipmontagefläche und die Bauelementmontagefläche einen rechten Winkel zueinander bilden.

Die Lötanschlüsse naben vorteilhaft eine Dicke von ungefähr 0,2mm bis 0,5mm. Das SMT-Miniaturgehäuse ist für optoelektronische Halbleiterbauelemente, insbesondere für seitlich optische Strahlung empfangende bzw. sendende Optohalbleiter, sogenannte Sidelooker, besonders geeignet.

Das zweipolige SMT-Miniaturgehäuse wird erfindungsgemäß so hergestellt, daß in einem Leadframe als fertige Lötanschlüsse dienende Leadframeteile durch Stanzen gefertigt werden, und daß dann der Halbleitercnip auf das eine Leadframeteil montiert und mit dem anderen Leadframeteil kontaktiert wird. Der Halbleiterchip wird in ein Gehäuse durch Vergießen, Umpressen oder Umspritzen so eingekapselt, daß die rechtwinkligen Schenkel der fertigen Lötanschlüsse an zwei gegenüberliegenden Außenseiten des Genäuses bis mindestens zu dessen Boden- bzw. Montagefläche gefünrt werden. Das fertige SMT-Miniaturgenäuse braucht dann nur noch aus dem Leadframe freigestanzt werden. In dieser Tecnnik hergestellte Bauelemente werden dann z.B. auf einen PCB so aufgelötet, daß die Chip-Montagefläcne senkrecht zum PCB steht.

Die mit der Erfindung erzielten Vorteile bestenen insbesondere darin, daß beim Herstellen des SMT-Miniaturgehäuses der Fertigungsscnritt des Trimmens und Formens der Lötanschlüsse eingespart wird und in den Stanzvorgang zur Leadframe-Formgebung integriert wird. Die Lötanscnlüsse müssen in ihrer gestanzten Form als fertige Bauteile dann nur noch aus dem Leadframe freigestanzt werden. Daraus resultiert, daß kein Biegestreß mehr auf das Bauelement ausgeübt wird und beispielsweise das Auftreten von Mikrorissen verhindert wird. Dadurch, daß kein Biegen der Lötanschlüsse mehr notwendig ist, treten auch weniger Toleranzabweichungen beim fertigen Gehäuse auf. Damit wird vor allem die Maßhaltigkeit der Lötanschlüsse verbessert. Durch entsprechende Leadframe-Gestaltung ist es möglich, auch ein Deflashen der Anschlüsse nach dem Einkapseln zu vermeiden. Insbesondere kann die Verlustleistung der Bauelemente durch Verwendung dickerer Leadframes als bei bekannten Gehäusen erhöht werden. Zudem ist das Gehäuse, bedingt durch die verbesserte Anordnung von Chip und Leadframe bzw. Lötanschlüssen, weiter miniaturisierbar.

Anhand von in den Figuren der Zeichnung dargestellten Ausführungsbeispielen wird die Erfindung im folgenden weiter erläutert. Es zeigen
- FIG 1: ein SMT-Miniaturgehäuse in Seitenansicht,
- FIG 2: eine Draufsicht auf das Gehäuse der FIG 1,
- FIG 3: ein weiteres SMT-Miniaturgehäuse in Seitenansicht und
- FIG 4: eine Draufsicht auf das Gehäuse der FIG 3.

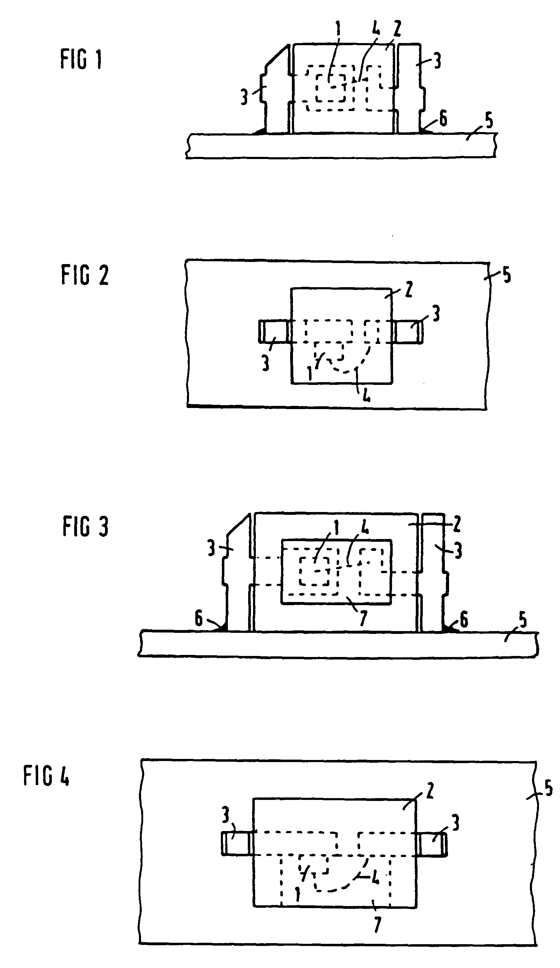

Das in den FIG 1 und 2 dargestellte zweipolige SMT-Miniaturgehäuse ist in Leadframetechnik hergestellt. Dabei ist ein Halbleiterchip 1 auf ein Leadframeteil montiert und mit einem weiteren Leadframeteil mittels eines Drahtes 4 kontaktiert. Die beiden Leadframeteile sind als Lötanschlüsse 3 aus dem Gehäuse 2 herausgeführt, in das als Chip 1 beispielsweise eine IRED, LED oder Photodiode eingekapselt ist. Die beiden Lötanschlüsse 3 sind in einem Stanzvorgang aus dem Leadframe mit den gewünschten Konturen als fertige Lötanschlüsse 3 ausgestanzt und müssen daher nicht mehr nachgeformt werden. Nach dem Stanzvorgang wird der Halbleiterchip 1 auf den einen Leadframeteil bzw. Lötanschluß 3 montiert und dann durch Vergießen, Umpressen oder Umspritzen in Kunststoff eingekapselt. Die beiden Lötanschlüsse 3 sind dabei als Stanzteile des Leadframes von einander gegenüberliegenden Gehäuseseitenwänden abstehend mindestens bis zum die Bauelementmontagefläche bildenden Boden des Gehäuses 2 geführt. Chipmontagefläche und Bauelementmontagefläche bzw. Bodenfläche des Gehäuses 2 bilden dabei einen rechten Winkel zueinander. Die fertiggestellten SMT-Miniaturgehäuse werden dann so auf eine Platine bzw. Leiterplatte 5 aufgelötet, daß die Chipmontagefläche bzw. die vom Leadframe aufgespannte Fläche senkrecht zur Leiterplatte 5 bzw. zum PCB steht.

Das in den FIG 3 und 4 dargestellte zweipolige SMT-Miniaturgehäuse wird für optoelektronische Halbleiterbauelemente mit seitlicher Abstrahl- bzw. Empfangscharakteristik verwendet. Solche Bauelemente werden auch Sidelooker genannt. Das SMT-fähige Gehäuse besteht aus den beiden, die Lötanschlüsse 3 bildenden Leadframeteilen, die aus dem Leadframe in der gewünschten Formgebung ausgestanzt werden. Auf das eine Leadframeteil wird als Halbleiterchip 1 ein Optohalbleiter montiert und über einen Bonddraht 4 mit dem zweiten Leadframeteil bzw. Lötanschlußteil 3 kontaktiert. Die Chipmontage kann dabei auch auf einen vorgehäusten Leadframe erfolgen. Denn bei diesem Ausführungsbeispiel ist im Gehäuse 2 ein als Reflektor 7 dienender Raum ausgespart, in dem der Chip 1 nach erfolgter Montage mit einem transparenten Gießharz vergossen wird, so daß der gewünschte sogenannte Sidelooker erzeugt wird. Chipmontagefläche und elementmontagefläche bilden wiederum einen rechten Winkel zueinander. Das fertige Produkt kann dann z.B. auf einen PCB bzw. auf eine Leiterplatte 5 so aufgelötet werden, daß die Chipmontagefläche senkrecht auf der Fläche steht, die von der Leiterplatte 5 gebildet wird. Das Verlöten des SMT-Miniaturgehäuses mit einer Leiterplatte 5 ist in den Figuren 1 und 3 mit dem Lötminiskus 6 angedeutet.

## Patentansprüche

1. Zweipoliges SMT-Miniaturgehäuse in Leadframetechnik für Halbleiterbauelemente, bei dem ein Halbleiterchip auf ein Leadframeteil montiert und mit einem weiteren Leadframeteil kontaktiert ist, die als Lötanschlüsse aus dem Gehäuse herausgeführt sind, in das der Chip eingekapselt ist, **dadurch gekennzeichnet**, daß die Lötanschlüsse (3) als fertige Bauteile in Form von Stanzteilen des Leadframes von gegenüberliegenden Gehäuseseitenwänden seitlich abstehend mindestens bis zum die Bauelementmontagefläche bildenden Gehäuseboden geführt sind, wobei die Chipmontagefläche und die Bauelementmontagefläche einen rechten Winkel zueinander bilden.

2. Gehäuse nach Anspruch 1, **dadurch gekennzeichnet**, daß die Lötanschlüsse eine Dicke von ungefähr 0,2mm bis 0,5mm haben.

3. Gehäuse nach Anspruch 1 oder 2, **dadurch gekennzeichnet**, daß das Halbleiterbauelement ein optoelektronisches Bauelement ist.

4. Gehäuse nach einem der Ansprüche 1 bis 3, **dadurch gekennzeichnet**, daß das Halbleiterbauelement ein seitlich empfangendes oder sendendes optoelektronisches Bauelement ist.

5. Verfahren zum Herstellen eines Gehäuses nach einem der Ansprüche 1 bis 4, **dadurch gekennzeichnet**, daß in einem Leadframe als fertige Lötanschlüsse (3) dienende Leadframeteile gestanzt werden, daß der Halbleiterchip (1) dann auf das eine Leadframeteil montiert und mit dem anderen kontaktiert wird, und daß der Halbleiterchip (1) in ein Gehäuse (2) so eingekapselt wird, daß die rechtwinkligen Schenkel der fertigen Lötanschlüsse (3) an zwei gegenüberliegenden Außenseiten des Gehäuses bis mindestens zu dessen Boden- bzw. Montagefläche geführt werden, wobei zwischen der Chipmontagefläche und der Bauelementmontagefläche ein rechter Winkel gebildet wird.

## Claims

1. Two-pole SMT miniature housing using lead frame technology for semiconductor components, in which a semiconductor chip is mounted onto one lead frame part and makes contact with a further lead frame part, which lead frame parts are guided out of the housing as soldering terminals, in which housing the chip is encapsulated, characterized in that the soldering terminals (3) are guided as finished structural parts in the form of stampings of the lead frame, projecting laterally from opposite housing side walls, at least as far as the housing bottom which forms the component mounting surface, the chip mounting surface and the component mounting surface forming a right angle with one another.

2. Housing according to Claim 1, characterized in that the soldering terminals have a thickness of approximately 0.2 mm to 0.5 mm.

3. Housing according to Claim 1 or 2, characterized in that the semiconductor component is an optoelectronic component.

4. Housing according to one of Claims 1 to 3, characterized in that the semiconductor component is a laterally receiving or transmitting optoelectronic component.

5. Method for producing a housing according to one of Claims 1 to 4, characterized in that lead frame parts serving as finished soldering terminals (3) are stamped in a lead frame, in that the semiconductor chip (1) is then mounted onto the one lead frame part and makes contact with the other lead frame part, and in that the semiconductor chip (1) is encapsulated in a housing (2) in such a way that the right-angled limbs of the finished soldering terminals (3) are guided, on two opposite outer sides of the housing, at least as far as the bottom or mounting surface of the latter, a right angle being formed between the chip mounting surface and the component mounting surface.

## Revendications

1. Boîtier miniature CMS à deux pôles dans la technique à cadre de montage pour composants à semiconducteur, dans lequel une puce à semiconducteur est montée sur une pièce de cadre de montage et est mise en contact avec une autre pièce de cadre de montage, lesquelles pièces de cadre de montage sortent, en tant que bornes de brasage, du boîtier dans lequel la puce est encapsulée, caractérisé en ce que les bornes (3) de brasage mènent, en tant que pièces constitutives fabriquées sous forme de pièces découpées dans le cadre de montage, de parois latérales du boîtier en vis-à-vis, en étant par leur côté à distance l'une de l'autre, au moins jusqu'au fond du boîtier formant la surface de montage du composant, la surface de montage de la puce et la surface de montage du composant étant à angle droit.

2. Boîtier suivant la revendication 1, caractérisé en ce que les bornes de brasage ont une épaisseur d'environ 0,2 mm à 0,5 mm.

3. Boîtier suivant la revendication 1 ou 2, caractérisé en ce que le composant à semiconducteur est un composant optoélectronique.

4. Boîtier suivant l'une des revendications 1 à 3, caractérisé en ce que le composant à semiconducteur est un composant optoélectronique recevant ou émettant par un côté.

5. Procédé de fabrication d'un boîtier suivant l'une des revendications 1 à 4, caractérisé en ce que l'on découpe dans un cadre de montage des pièces de cadre de montage servant de bornes (3) de brasage fabriquées, puis l'on monte la puce (1) à semiconducteur sur l'une des pièces de cadre de montage, on la met en contact avec l'autre pièce de cadre de montage et l'on insère la puce (1) à semiconducteur dans un boîtier (2), de telle sorte que les branches à angle droit des bornes (3) de brasage fabriquées mènent à deux côtés extérieurs en vis-à-vis du boîtier jusqu'à au moins sa surface de fond de montage, un angle droit étant formé entre la surface de montage de la puce et la surface de montage du composant.
